# EUROPEAN PATENT APPLICATION

(11) **EP 2 365 515 A1**
(43) Date of publication of application: **14.09.2011**
(21) Application number: 10155977.1
(22) Date of filing: 09.03.2010
(51) Int. Cl.: H01J 37/34, C23C 14/34

(54) **Rotatable target, backing tube, sputtering installation and method for producing a rotatable target**

(71) Applicant: Applied Materials, Inc., Santa Clara, CA 95054 (US)
(72) Inventor: Lippert, Lothar, 63801 Kleinostheim (DE); Buschbeck, Wolfgang, 63454 Hanau (DE)
(74) Representative: Zimmermann & Partner

(57) **Abstract**

A rotatable target (100) for a sputtering installation (200) and a method for producing a rotatable target (100) are provided. The target (100) includes a backing tube (10) to which a target tube (20) is shrink-fitted. The method includes setting a positive temperature difference between a target tube (20) and a backing tube (10). The method further includes pulling the target tube (20) over the backing tube (10) while the temperature difference remains positive. Furthermore, a backing tube (10) having a middle part (110) with an outer lateral area (12a) and a notch (15) extending in a longitudinal direction on the outer lateral area (12a) is provided.

## Description

### FIELD OF THE INVENTION

The present disclosure relates to a rotatable target for sputtering installations, particularly to a rotatable target including a backing tube and a target tube disposed around the backing tube. Further, the present disclosure relates to a backing tube which is adapted to receive a target tube and to a method for producing a rotatable target. Additionally, the present disclosure relates to a sputtering installation including a rotatable target.

### BACKGROUND OF THE INVENTION

In many applications it is desired to deposit thin layers on a substrate. Known techniques for depositing thin layers are in particular evaporating, chemical vapor sputtering and sputtering deposition. For example, sputtering can be used to deposit a thin layer such as a thin layer of aluminum or ceramics. During the sputtering process, the coating material is transported from a sputtering target consisting of that material to the substrate to be coated by bombarding the surface of the target with ions of a typically inert processing gas. The ions are produced by electron impact ionization of the processing gas and accelerated by a high voltage drop between the target operating as a sputtering cathode and an anode. This bombardment of the target results in an ejection of atoms of the coating material, which accumulate as a deposited film on the substrate arranged opposite to the sputtering cathode.

Segmented planar, monolithic planar and rotatable targets may be used for sputtering. Due to the geometry and design of the cathodes, rotatable targets typically have a higher utilization and an increased operation time than planar ones.

Rotatable sputtering cathodes may be made of a hollow cylindrical body of the target material. These sputtering cathodes are also referred to as monolithic targets and may be manufactured by casting or sintering of the target material.

Non-monolithic rotatable sputtering cathodes typically include a cylindrical rotatable tube, e.g. a backing tube, having a layer of the target material applied to the outer surface thereof. In the manufacture of such rotatable sputtering cathodes, the target material may for example be applied by spraying onto, or casting or isostatic pressing of powder onto the outer surface of a backing tube. Alternatively, a hollow cylinder of a target material, which may also be referred to as a target tube, may be arranged on and bonded, e.g. with indium, to the backing tube for forming a rotatable target.

In order to obtain increased deposition rates, the use of magnetically enhanced cathodes has been proposed. This may also be referred to as magnetron sputtering. Magnetic means, which may include an array of magnets, may be arranged inside the sputtering cathode, e.g. inside the backing tube, and provide a magnetic field for magnetically enhanced sputtering. The cathode is typically rotatable about its longitudinal axis so that it can be turned relative to the magnetic means.

The target material of typical sputtering targets may be depleted or consumed quickly, e.g. within a week, during sputtering. A major portion of operating costs of sputtering installations is target costs. Accordingly, there is an ongoing need for improved and/or more cost-efficient rotatable targets, e.g. reusable target tubes, and improved manufacturing and reprocessing methods for rotatable targets.

### BRIEF DESCRIPTION

In view of the above, a rotatable target, a sputtering installation, a backing tube for a rotatable target, and a method for producing a rotatable target are provided.

According to an embodiment, a rotatable target for sputtering installations is provided. The rotatable target includes a backing tube and a target tube which is shrink-fitted to the backing tube.

According to an embodiment, a backing tube, which is adapted to receive a target tube, is provided. The backing tube includes a first end region adapted to be mounted to a sputtering installation and a second end region arranged opposite to the first end region. The backing tube further includes a middle part having an outer lateral area and a notch extending in a longitudinal direction on the outer lateral area.

According to a further embodiment, a sputtering installation with at least one rotatable target, having a target tube shrink-fitted to a backing tube, is provided.

According to an embodiment, a method for producing a rotatable target is provided. A backing tube which is adapted to be mounted to a sputtering installation and a target tube are provided. A temperature difference between a first temperature of the target tube and a second temperature of the backing tube is set. The temperature difference is larger than zero. Furthermore, the method includes pulling the target tube over the backing tube while the temperature difference remains larger than zero.

According to an embodiment, a method for producing a rotatable target for sputtering installations is provided. The method includes providing a backing tube and providing a target tube. The method further includes forming a shrink fit connection between the target tube and the backing tube.

Further aspects, advantages and features of the present invention are apparent from the dependent claims, the description and the accompanying drawings.

### BRIEF DESCRIPTION OF THE DRAWINGS

Some of the above mentioned embodiments will be described in more detail in the following description of typical embodiments with reference to the following drawings in which:

Fig. 1 shows schematically a cross section of a rotatable target along its longitudinal axis according to embodiments;

Fig. 2 shows schematically a cross section of a backing tube along the line AA' of Fig. 1 according to embodiments;

Fig. 3 shows schematically a cross section of a target tube along the line AA' of Fig. 1 according to embodiments;

Fig. 4 shows schematically a cross section of a rotatable target along the line AA' of Fig. 1 according to embodiments;

Fig. 5 shows schematically a cross section of a rotatable target along its longitudinal axis according to embodiments;

Fig. 6 shows schematically a cross section of a backing tube along its longitudinal axis according to embodiments;

Fig. 7A shows schematically a cross section of a backing tube along the line AA' of Fig. 6 according to embodiments;

Fig. 7B shows schematically a cross section of a backing tube along the line BB' of Fig. 6 according to embodiments;

Fig. 8 shows schematically a cross section of a sputtering installation according to embodiments;

Fig. 9 illustrates a manufacturing method according to one or more embodiments;

Fig. 10 illustrates a manufacturing method according to one or more embodiments;

Fig. 11 illustrates a manufacturing method according to one or more embodiments.

The elements of the drawings are not necessarily to scale relative to each other. Like reference numerals designate corresponding similar parts.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

The process of coating a substrate as a material at the scraping refers typically to thin film applications. The term "coating" and the term "depositing" are used synonymously herein.

The term "substrate" as used herein shall embrace both inflexible substrates, e.g. a wafer or a glass plate, and flexible substrates such as webs and foils.

Representative examples include (but are not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

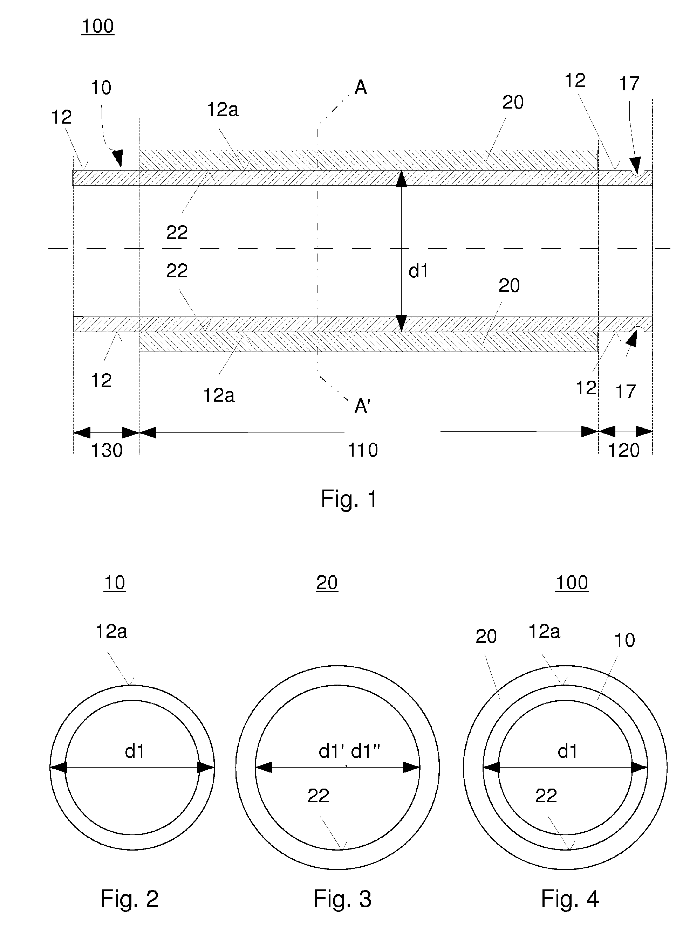

With respect to Fig. 1, several embodiments pertaining to rotatable targets are explained. The term "rotatable target" as used herein shall embrace any cathode assembly which is adapted to be rotatably mounted to a sputtering installation and which includes a target structure adapted for being sputtered. The term "rotatable target" as used herein shall particularly embrace magnetically enhanced cathode assemblies which in addition include internal magnetic means, e.g. permanent magnets, for improved sputtering.

Typically, the rotatable target includes a backing tube and a target tube disposed on the backing tube. The term "target tube" as used herein shall embrace any shell, in particular formed as a hollow cylinder, of material suitable to be sputtered. Typical sputtering materials include (but are not limited to) pure metals such as aluminum (Al), copper (Cu), silver (Ag) and gold (Au), metal alloys such as such as an aluminum-niobium (AlNb) alloy or an aluminum-nickel (AlNi) alloy, semiconductor materials such as silicon (Si) and dielectric materials such as nitrides, carbides, titanates, silicates, aluminates and oxides, e.g. transparent conducting oxides (TCO) such as impurity-doped ZnO, In₂O₃, SnO₂ and CdO, as well as Sn doped In₂O₃ (ITO) and F doped SnO₂.

The term "backing tube" as used herein shall embrace any base body which is adapted to support a target tube and which is adapted to be rotationally locked and vacuum-tightly mounted to a sputtering installation, typically to an end block of a sputtering installation. Support of the target tube may include mechanical support, providing electrical contact and providing cooling of the target tube and the optional magnets.

In operation, un-cooled magnets may become hot. This is due to the fact that they are surrounded by target material that is bombarded with ions. The resulting collisions lead to a heating up of the rotatable target. In order to keep the magnets at a suitable operating temperature, a cooling of the target material and the magnets is typically provided within the backing tube.

Typically, the backing tube includes a hollow cylindrical shell onto which the target tube is fixed. The target tube is typically joined onto an outer peripheral surface of the backing tube. The backing tube and the target tube are typically arranged coaxially, i.e. the cylinder axis of the target tube and the cylinder axis of the backing tube form a common rotational axis of the rotatable target around which the rotatable target may be rotated during sputtering. The term "longitudinal" as used in this specification intends to describe an orientation in direction of the cylinder axis of the backing tube and the target tube, respectively. The term "longitudinal axis" as used in this specification intends to describe the cylinder axis of the rotatable target. The term "radial" as used in this specification intends to describe an orientation which is perpendicular to the longitudinal direction.

According to embodiments, which may be combined with other embodiments disclosed herein, the backing tube 10 of Fig. 1 has an outer surface 12 to which the target tube 20 is shrink-fitted. At least in the section to which the target tube is shrink fitted to, the backing tube 10 is typically formed as a hollow cylinder and the outer surface 12 is formed by the outer lateral area 12, i.e. the outer cylinder surface 12 of the hollow cylinder. In the following the outer cylinder surface 12 is also referred to as outer surface 12. Further, the target tube 20 is typically coaxially arranged around the backing tube 10 as illustrated by the dashed line. The dashes line represents the longitudinal axis of the rotational target which is identical to the cylinder axis of the backing tube 10 and the cylinder axis of the target tube 20.

The rotatable target 100 is typically rotated around the longitudinal axis during a sputtering process. Typically, the target tube 20 has an inner lateral area 22 which forms the inner cylinder surface 22 and adjoins at least a part 12a of the outer surface 12 of the backing tube 10. The inner lateral area 22 of the target tube 20 and the part 12a of the outer surface 12 of the backing tube 10 are typically pressed against each other such that a fastening between the target tube 20 and the backing tube 10 is achieved by friction. Pressing the backing tube 10 and the target tube 20 against one another ensures a good heat transfer and in the case of conductive backing tube 10 and conductive target tube 20 a good electric contact.

In other words, an interference fit or press fit is formed between the target tube and the backing tube by employing the phenomenon of thermal expansion. Additional fastening means are typically not required but may additionally be used e.g. for safety reasons. In particular, tedious and expensive bonding e.g. with iridium may be avoided. Further, a worn target tube may be removed from the backing tube and thus the backing tube reused.

Typically, both the target tube 20 and at least a middle part 110 of the backing tube 10 for receiving the target tube 20 are shaped as hollow cylinders with ring shaped cross section. In the assembled state, the middle part 110 has typically a first outer diameter d1 and an inner diameter of the target tube 20 is equal to the first outer diameter d1.

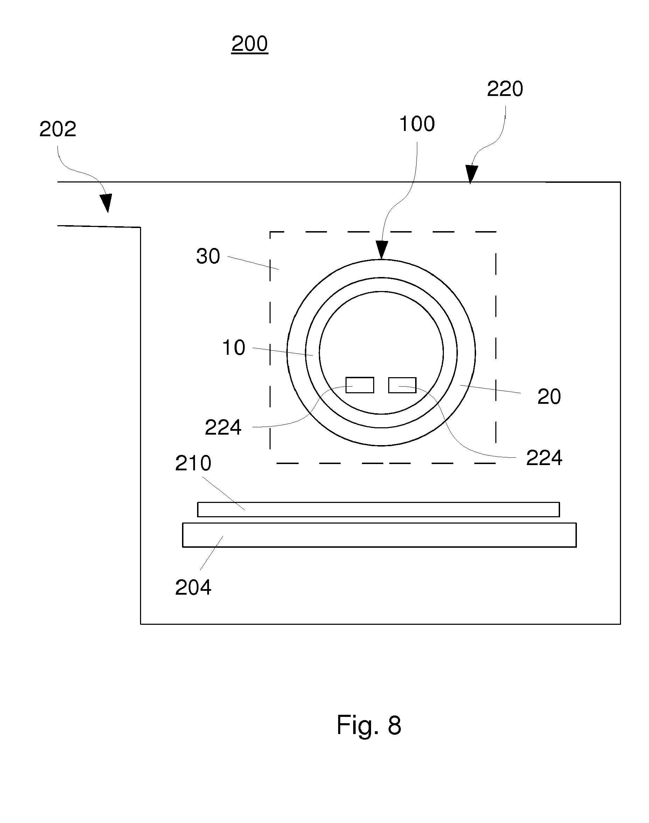

According to embodiments, which may be combined with other embodiments disclosed herein, the backing tube 10 further includes a first end region 120 which is adapted to be mounted to a sputtering installation, as shown below in Fig. 8, typically to an end-block of the sputtering installation. This is indicated in Fig. 1 by the circumferential groove 17 into which a fixation coupling may be clasp.

An important factor to be considered is the fact that the rotatable target 100 is, during operation of the sputtering installation, typically located in a vacuum environment. The backing tube 10 of the rotatable target 100 is typically rotationally locked and vacuum-tightly mounted to an end-block of the sputtering installation.

A second end region 130 providing a vacuum tight seal is typically arranged at a longitudinal end of the backing tube 10 which is opposite to the first end region 120.

In embodiments, at least two, for example three, four or more, hollow cylindrical target elements are disposed side by side around the backing tube 10 in its middle region 110 and form the target tube 10. This typically facilitates the assembly of the rotatable target 100 in particular for comparatively soft or ductile sputtering materials such as elemental or pure aluminum. Note that the thickness of the shell of a typical hollow target tube 10 is in the mm range. The longitudinal extension of the target tube 10 may be up to several meters. Assembling several longitudinal shorter target elements typically avoids or at least reduces possible deformations of comparatively soft target materials prior to and during assembly. The number and the kind of target elements may depend on the material to be sputtered and the longitudinal extension of the target tube 20.

To allow for assembling of target tube 20 and backing tube 10, at least one of the maximum outer diameters of the first and second end region 120, 130 is equal to or smaller than the first outer diameter d1 of the target tube 20. In the embodiment of Fig. 1, the maximum outer diameters of the first and second end region 120, 130 are equal to the first outer diameter d1 of the target tube 20.

In a typical embodiment, at least a part of the outer surface of the backing tube and an inner lateral area of the target tube are pressed against each other.

According to an embodiment, the backing tube includes a middle part having a first outer diameter and an outer lateral area which adjoins the inner lateral area of the target tube. The first end region is typically adapted to be mounted to the sputtering installation and has an outer diameter which is equal to or smaller than the first outer diameter. The backing tube may further include a second end region arranged in longitudinal direction opposite to the first end region.

Further embodiments are explained with respect to Figs. 2 to 4 showing typical cross-sectional views along the line AA' of Fig. 1. Accordingly, Fig. 2 corresponds to a cross-section through the middle portion 110 of the backing tube 10. The middle portion 110 has a maximum outer diameter d1 and an outer lateral area 12a. The outer lateral area 12a forms a part 12a of the outer surface 12 of the backing tube 10.

The outer lateral area 12a is typically adapted to receive the target tube 20 and to form a surface contact, typically a large-area surface contact, with the inner lateral area 22 of the target tube 20 illustrated in Fig. 3. Typically, the outer lateral area 12a and the inner lateral area 22 have a low surface roughness, e.g. below about 0.05 mm or even below about 0.02 mm, to reduce fitting work and/or to ensure a large-area surface contact. With a large-area surface contact an efficient heat transfer from the sputtered target tube 20 to the typically cooled backing tube 10 may be provided.

A low Ohmic connection between the typically electrically conductive backing tube 10 and the typically electrically conductive target tube 20 may be realized in this way. In the event of a sufficiently ductile target material, e.g. pure aluminum, the surface roughness of the inner lateral area 22 of the target tube 20 is typically lower than about 0.05 mm.

The large-area surface contact is typically formed by shrink-fitting the target tube 20 to the backing tube 10. For example, the outer diameter d1 of the backing tube 20 is, at a given temperature, chosen substantially equal to or slightly larger than the inner diameter d1' of the target tube 20, at the given temperature. In certain embodiments, the outer diameter d1 of the backing tube 20 is, at the given temperature, about 0.01 mm to about 0.1 mm larger than the inner diameter d1' of the target tube 20 to allow for forming a stable press fit and/or to compensate for the surface roughness of both parts 10, 20. The difference in the diameters d1 and d1' is typically chosen in accordance with the tensile strengths and/or the modulus of rupture of the material of the target tube 20. In the event of shrink-fitting a ductile target material, e.g. pure aluminum, to the backing tube 10, the target material may become partially plastic, i.e. more ductile, at the given temperature. Accordingly, the achievable contact pressure between the backing tube 20 and the target tube 10 of a ductile target material is typically determined by the elastic limit of the target material at the given temperature.

For assembly of a rotatable target 100, the target tube 20 is typically thermally expanded such that the internal diameter of the target tube 20 increases to a value d1" which is larger than the outer diameter d1 of the backing tube 20.

Alternatively and/or in addition, the backing tube 10 may be cooled. Thereafter, the target tube 20 may be arranged in the expanded state coaxially around the backing tube 10. After cooling the target tube 20 and temperature equalization between the target tube 20 and the backing tube 10, respectively, a shrink fit connection between the backing tube 10 and the target tube 20 is typically formed by the shrinkage of the target tube 20 and/or expansion of the backing tube 10.

Typically, the backing tube 10 is more rigid compared to the target tube 20. Therefore, the interface of the shrink fit, which is formed between and by, respectively, the inner lateral area 22 of the target tube 20 and the outer lateral area 12a of the backing tube 10, has a diameter which is, at given temperature, substantially equal to the diameter d1 of middle portion 110 as indicated in Fig. 4.

As the outer diameter d1 of the non-assembled backing tube 20 is, at given temperature, typically chosen slightly larger than the inner diameter d1' of the non-assembled target tube 20, the outer lateral area 12a and the inner lateral area 22 are, in an embodiment, pressed against each other in the assembled rotatable target 100. In other words, the rotatable target 100 includes a press-fit or interference fit between the backing tube 10 and the target tube 20 formed by shrink-fitting.

According to embodiments, which may be combined with other embodiments disclosed herein, the backing tube 10 has a first coefficient of expansion and the target tube 20 has a second coefficient of expansion which is equal to or smaller than the first coefficient of expansion. During sputtering, the target tube 20 is typically hotter than the backing tube 10. If the second coefficient of expansion is smaller than the first coefficient of expansion, lowering of the contact pressure of the formed press-fit by heating up the rotatable target 100 during sputtering can at least be reduced. Typically, the second coefficient of expansion is equal to or smaller than the first coefficient of expansion at least in a temperature range from about 0°C to temperatures of about 300 °C, more typically to about 250° C, typically reached during sputtering. In doing so, the formed press-fit remains stable during sputtering conditions.

For example, the target tube 20 is made of a pure metal, such as gold, silver or copper and the backing tube 10 is made of a steel alloy having an appropriate coefficient of thermal expansion. The coefficient of thermal expansion of steel varies between about 9.53*10⁻⁶ K⁻¹ for "DuraTech M4" of Latrobe Steel to about 18.8*10⁻⁶ K⁻¹ for "Outokumpu 4841" of Outokumpu. For example, a backing tube 10 made of "Sanicro 41" steel from Sandvik having a coefficient of thermal expansion of about 14.2*10⁻⁶ K⁻¹ may be combined with a gold target tube having also a coefficient of thermal expansion of about 14.2*10⁻⁶ K⁻¹).

In a typical embodiment, which may be combined with other embodiments disclosed herein, the backing tube 10 includes the material the target tube 20 is made of. For example, the target tube 20 is made of a pure metal, e.g. aluminum or copper, and the backing tube 10 is made of an alloy of that metal, e.g. an aluminum alloy and a copper alloy, respectively. In another example, the target tube 20 is made of an alloy, e.g. an aluminum niobium (AlNb) alloy or an aluminum neodymium (AlNd) alloy and the backing tube 10 is also made of an aluminum alloy, typically a mechanically more stable aluminum alloy. Thereby essentially equal coefficients of thermal expansion of the backing tube 10 and the target tube 20 can be realized.

In typical embodiments, the coefficient of expansion of the target tube is equal to or smaller than the coefficient of expansion of the backing tube.

According to embodiments, the backing tube and the target tube comprise the same material, i.e. a first material, e.g. the same metal or metals, but may be differently composed, e.g. composed of different metal alloys. The backing tube may e.g. comprise the material of which the target tube is made.

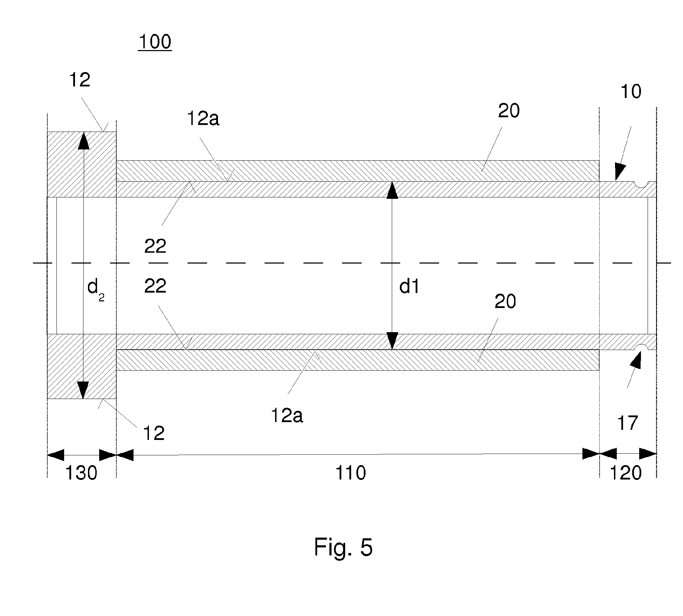

With respect to Fig. 5 showing in a cross-sectional view a rotatable target 100 along its longitudinal axis, further embodiments are explained. The rotatable target 100 of Fig. 5 is similar to the rotatable target 100 of Fig. 1. However, only the maximum outer diameter of the first end region 120 is equal to the first outer diameter d1 of the backing tube 10 in Fig. 5. In the embodiment of Fig. 5, the second end region 130 of the backing tube 10 has a maximum diameter d2 which is larger than the first outer diameter d1 of the middle part 110. Thereby, an end stop, typically a circumferential end stop, for the target tube 20 is provided.

The end stop may generally be used as an assembly aid for forming the rotatable target, e.g. for properly disposing the target tube on and around the backing tube. Alternatively and/or in addition, the end stop may secure the target tube or, when the target tube includes several sections, at least one adjoining section of the target tube is secured against movement in a longitudinal direction towards the second end region during transportation and/or during use in a sputtering installation.

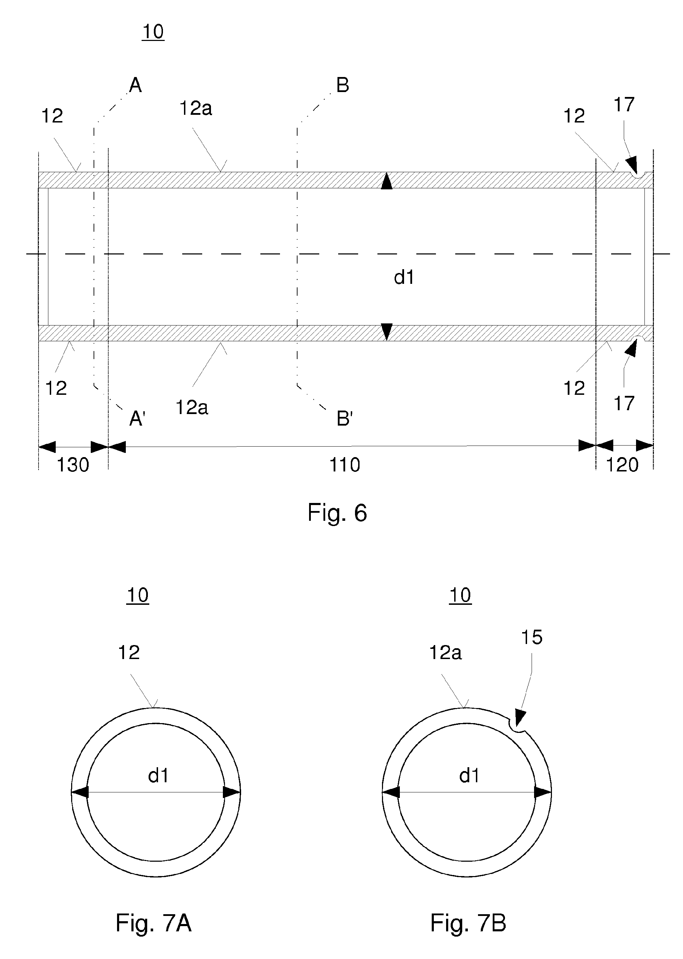

With respect to Figs. 6, 7A and 7B further typical embodiments are explained. Figs. 6, 7A and 7B illustrate a backing tube 10 in a cross section along the longitudinal axis of the backing tube 10 shown as a dashed line in Fig. 6, in a cross-sectional view along the line AA' of Fig. 6 and in a cross-sectional view along the line BB' of Fig. 6, respectively. The cross sections through the middle part 110 in Fig. 7B and the second end region 130 in Fig. 7A are orthogonal to the cross section of Fig. 6.

According to embodiments, which may be combined with other embodiments disclosed herein, the backing tube 10 has, in a middle part 110, a notch 15 on the outer lateral area 12a which extends in a longitudinal direction of the backing tube 10. Typically, the notch 15 extends in the longitudinal direction along the whole middle part 110, i.e. from the first end region 120 to the second end region 130. The middle part 110 is typically formed as a hollow cylinder and adapted to receive a rotatable target.

The notch 15 may have a lateral extension of about 1 mm to about 5 mm and extends about 0.5 mm to about 2 mm from outside into the shell of the backing tube 10 but does not go through the shell. Typically, the longitudinal extension of the notch 15 is about 5 mm to about 10 mm larger than the longitudinal extension of the backing tube. The notch 15 typically facilitates the removal of a worn target tube by cutting or milling the worn target tube along the notch 15. This will be explained in more detail below. In other words, the backing tube 10 is adapted to be reused.

According to embodiments, which may be combined with other embodiments disclosed herein, the backing tube has a partial flattening which extends in the longitudinal direction. Typically, at least the outer lateral area of the middle part has a flat area which extends in the longitudinal direction of the backing tube. For example, the middle part may, in a cross section which is perpendicular to the longitudinal axis, have an outer boundary of circular shape except in a small angular range in which the outer boundary is essentially straight. The geometry of the partial flattening is typically chosen such that a narrow interspace, which extends in the longitudinal direction of the backing tube 10, is formed between at least a part of the partial flattening and the target tube after shrink fitting the target tube to the backing tube. The lateral extension of the narrow interspace typically ranges from about 1 mm to about 5 mm. Typically, the longitudinal extension of the partial flattening is about 5 mm to about 10 mm larger than the longitudinal extension of the backing tube. The partial flattening typically facilitates the removal of a worn target tube by cutting or milling the worn target tube along the narrow interspace and the partial flattening, respectively.

According to embodiments, a rotatable target includes a target tube which is shrink-fitted to a backing tube having a notch on the outer lateral area. The notch typically extends in a longitudinal direction of the backing tube.

According to embodiments, the backing tube includes a middle part having a first outer diameter and an outer lateral area to which the backing tube is shrink-fitted to, and a first end region which is adapted to be mounted to a sputtering installation, typically to an end-block of the sputtering installation.

The first end region has an outer diameter which is equal to or smaller than the first outer diameter.

Typically, a second end region is arranged at an end of the backing tube which is opposite to the first end region. According to embodiments, the second end region has a maximum outer diameter which is larger than the first outer diameter.

In embodiments, the middle part of the backing tube has a notch which typically extends in a longitudinal direction of the backing tube on the outer lateral area.

Fig. 8 illustrates in a schematic cross-section a sputtering installation 200. According to an embodiment, the sputtering installation 200 has a vacuum chamber 220 including a gas inlet 202 for providing processing gas, for example argon, to the vacuum chamber 220. The vacuum chamber 220 further includes a substrate support 204 and a substrate 210 arranged on the substrate support 204. Further, the vacuum chamber 220 includes a rotatable target 100, typically in a cantilevered arrangement above the substrate 210. The rotating axis corresponds, in an embodiment, to the cylinder axis or longitudinal axis defining a longitudinal direction of a cylindrical rotatable target 100. In an embodiment, the rotating axis is arranged substantially horizontal. In another embodiment, the rotating axis and the substrate 210 are arranged substantially vertical. The terms "substantially horizontal" and "substantially vertical" as used in this specification intend to describe an orientation in horizontal and vertical direction, respectively, with an angular accuracy of at least 5°. In some embodiments, it is possible to arrange the rotating axis in a tilted manner, for instance at an angle of between 3° and 10°, or at even larger angles. The rotatable target 100 is typically supported by an end-block 30 which is not visible in the shown cross-section and therefore drawn as a dashed rectangle.

Typically, the end-block 30 rotatably transfers movement, coolant and electrical current to the target while maintaining vacuum integrity and a closed coolant circuit.

The end-block 30 typically has a drive, typically a rotating electric motor, at least one rotary electrical contact, a bearing, as well as rotary coolant seals and vacuum seals.

The rotatable target 100 includes a backing tube 10 and a target tube 20 arranged around the backing tube 10. The target tube 20 provides the material to be sputtered. For example, the target tube 20 may include an elemental metal such as aluminum (Al) or copper (Cu), an alloy such as an aluminum-niobium (AlNb) alloy or an aluminum-nickel (AlNi) alloy or a semiconductor material such as silicon as a material to be sputtered.

In operation, the typically cylindrical rotatable target 100 rotates about its longitudinal axis which is orthogonal to the shown cross-section such that the material of the target tube 20 is worn or sputtered substantially regularly about its circumference. The longer the coating process takes place, the more material is sputtered, i.e. used, from target tube 20.

Typically, a high voltage difference is applied between the rotatable target 100 operating as a cathode and the substrate support 204 operating as an anode. The plasma is typically formed by impact ionization of accelerated electrons with e.g. Argon atoms. The formed Argon ions are accelerated in direction of the target tube 20 such that particles, typically atoms, of the target tube 20 are sputtered and subsequently deposited on the substrate 210.

In embodiments, other suitable gases, e.g. other inert gases such as krypton or a reactive gas such as oxygen or nitrogen may be used to create the plasma. According to typical embodiments, which can be combined with other embodiments described herein, the pressure in the plasma area can be about 10⁻⁴ mbar to about 10⁻² 2 mbar, typically about 10⁻³ mbar. In a further embodiment, the vacuum chamber 220 may include one or more openings and/or valves for introducing or retracting the substrate 210 in or out of the vacuum chamber 220.

The magnetron sputtering is particularly advantageous in that its deposition rates are rather high. By arranging one magnet 224 or more magnets 224 inside of the backing tube 10, free electrons within the generated magnetic field directly below the target surface may be trapped. This enhances the probability of ionizing the gas molecules typically by several orders of magnitude. In turn, the deposition rate may be increased significantly. Depending on the application and the material to be sputtered, stationary or time varying magnetic fields may be used. Furthermore, a cooling fluid is typically circulating within the backing tube 10 for cooling the magnets 224.

Even though Fig. 8 shows one rotatable target 100, according to different embodiments, which may be combined with other embodiments disclosed herein, two or more rotatable targets 100 may be disposed in the vacuum chamber 220. In a typical embodiment, the cylindrical axes of the two or more rotatable targets 100 are substantially parallel, i.e. parallel within an angular accuracy of at least 5°.

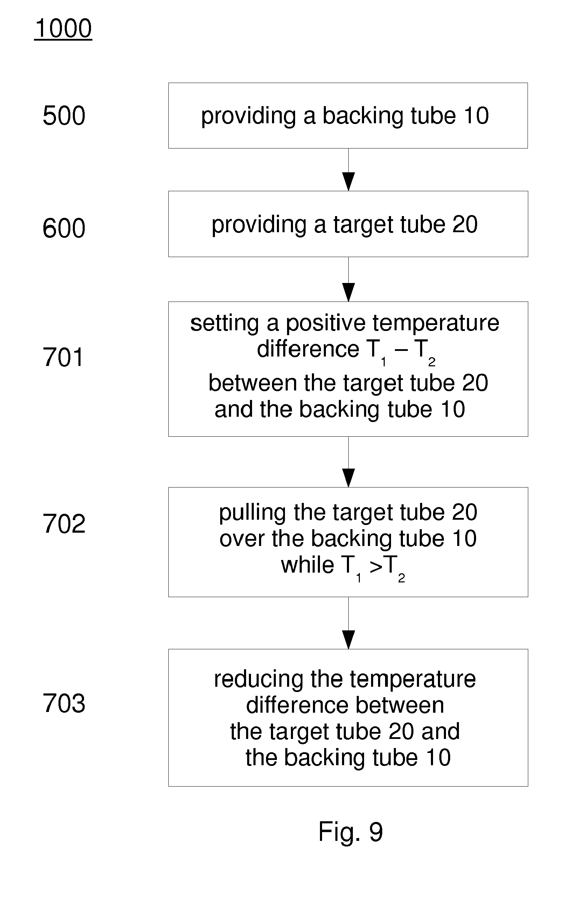

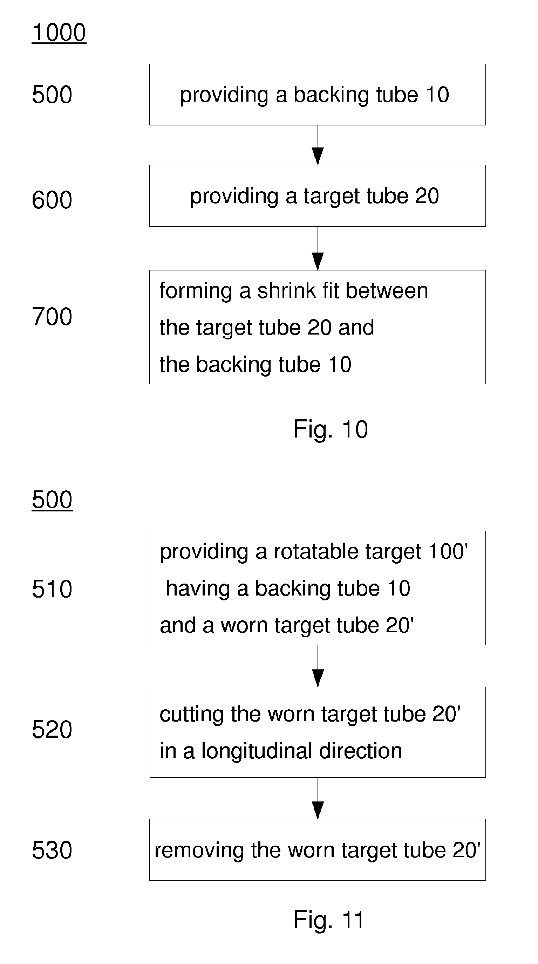

With respect to Figs. 9 and 11 manufacturing processes according to several embodiments are illustrated. Fig. 9 illustrates a method 1000 of producing a rotatable target for sputtering installations. In the two processes 500 and 600, which may also be reversed, a backing tube 10 and a target tube 20 are provided. In a process 701 a temperature difference δT between a first temperature T₁ of the target tube 10 and a second temperature T₂ of the backing tube is set. The temperature difference δT which is larger than zero, i.e. δT = T₁ - T₂ > 0.

The temperature difference δT is typically set large enough to ensure that an outer diameter d1 of the backing tube 10 is smaller, typically up to five microns or up to 50 microns, than an inner diameter of the target tube 20. This facilitates a subsequent process 702 of pulling the target tube 20 over the backing tube 10.

The absolute value of the initially set temperature difference δT typically depends on the coefficients of thermal expansion of the backing tube 10 and the target tube 20. During process 702, the temperature difference δT remains positive. It is typically large enough to ensure that the outer diameter d1 of the backing tube 10 remains smaller than the inner diameter of the target tube 20 during pulling the target tube 20 over the backing tube 10. Typically, the process 702 is carried out such that the initially set temperature difference δT remains substantially constant or decreases only slightly, i.e. by a about five percent or by about 20 percent. For example, the target tube 20 is pulled over the backing tube 10 with an initial temperature difference δT of about 100 K which decreases to a temperature difference δT of at least about 90 K.

In process 702, the target tube 20 or its segments are typically disposed on the outer surface 12, typically on the outer lateral area 12a of the middle part 110, of the backing tube 10. Further, the target tube 20 or its segments are typically arranged coaxially around the backing tube 10.

Setting the temperature difference δT is, in embodiments, achieved by heating the target tube 20 or its respective sections. This may be accompanied by cooling the backing tube 10 i.e. through an appropriate end-block supporting the backing tube 10 during assembly of the rotatable target. Cooling the backing tube 10 at least reduces thermal expansion of the backing tube 10 and, therefore, typically facilitates the subsequent process 702 of pulling the target tube 20 over the backing tube 10.

In a typical embodiment, which may be combined with other embodiments disclosed herein, the temperature difference δT between the target tube 10 and the baking tube 20 or a segment thereof reduced is in a subsequent step 703, e.g. by thermal relaxation, to form a shrink fit connection between the backing tube 10 and the target tube 20. Thereby a mechanically stable rotatable target is formed. Cooling of the backing tube 10 typically speeds up thermal relaxation.

In embodiments, the temperature difference is set by heating the target tube and/or cooling the backing tube.

In a typical embodiment, the temperature difference is set such that an inner diameter of the target tube is about 0.01 mm to about 1.5 mm, typically about 0.02 mm to about 0.5 mm, more typically about 0.025 mm to about 0.05 mm, larger than the outer diameter of the backing tube.

In a typical embodiment, the method further includes reducing the temperature difference to form a shrink fit connection between the target tube and the backing tube. Typically, the target tube and the backing tube are thermally equilibrated, i.e. the temperature difference is reduced to zero.

In a typical embodiment, forming a shrink fit connection includes setting a positive temperature difference between the backing tube and the target tube, disposing the target tube on the outer surface of the target tube, and reducing the positive temperature difference.

After forming the shrink fit connection, the formed rotatable target may be tempered for up to several hours to above room temperature to further strengthen the interconnection and/or to reduce the electric resistance.

The processes 701 to 703 may also be considered as sub processes of a process 700 of forming a shrink fit connection. This is illustrated in Fig. 10. According to embodiments, a shrink fit is formed between the target tube 20 and the backing tube 10 in a process 700 after providing a backing tube 10 and a target tube 20 in processes 500 and 600, respectively.

Typically, the backing tube has an outer surface onto which the backing tube is shrink fitted. The target tube may be provided as a single hollow body or in several hollow sections which are, in embodiments, successively shrink fitted to the backing tube. In another embodiment, the hollow sections are successively pulled on the backing tube and thereafter shrink fitted to the backing tube in a common process.

The process 700 typically includes setting a temperature difference δT which is larger than zero between the target tube 20 and the baking tube 10. This is, in embodiments, achieved by heating the target tube 20 or their respective sections and may be accompanied and/or replaced by cooling the backing tube 10 i.e. through an appropriate end-block supporting the backing tube 10 during assembly of the rotatable target.

In the case of heating the target tube 20, cooling the backing tube 10 at least reduces thermal expansion of the backing tube 10 when the target tube 20 or its segments are arranged on the backing tube 10 in a subsequent process. Accordingly, cooling the backing tube 10 typically facilitates the subsequent process of arranging the target tube 20 or its segments on the backing tube 10. According to embodiments, the target tube 20 or its segments are disposed on an outer surface, typically an outer lateral area of a middle part of the backing tube 10.

Further, the target tube or its segments are typically arranged coaxially around the backing tube. Thereafter, the temperature difference δT between the target tube and the baking tube or segments thereof is reduced, e.g. by thermal relaxation or partial thermal relaxation, to form a shrink fit connection. Cooling of the backing tube typically also speeds up reducing the temperature difference δT.

The method 1000 of producing a rotatable target of Fig. 9 and 10 typically includes: providing a backing tube 10 at a second temperature in block 500, providing a target tube 20 at a first temperature which is larger than the second temperature in block 600, and pulling over and arranging the target tube 20 coaxially around the backing tube 10 in block 700. For the latter process a large enough clearance between target tube 20 and the backing tube 10 is typically desirable.

In typical embodiments, which may be combined with other embodiments disclosed herein, the difference δT between the first temperature and the second temperature is set such that an inner diameter d1" of the target tube 20 or its segments is about 0.01 mm to about 1.5 mm larger than an outer diameter d1 of the backing tube 10 at least in the middle part 110 and one of the end regions 120, 130.

For example, a hollow aluminium cylinder 20 with an exemplary outer diameter of 100 mm is provided at room temperature as target tube 20 and a cylindrical aluminum alloy backing tube 10 with an exemplary outer diameter of 100.03 mm is provided at room temperature. Thereafter the aluminum target tube 20 is heated to a temperature of 100 K above room temperature (δT=100 K). The thermal expansion coefficient α of aluminum and the used aluminum alloy is about 23 10⁻⁶·K⁻¹. Accordingly, the thermal expansion in radial direction, i.e. in a direction which is orthogonal to the longitudinal direction, *δd* = *d* * *α* * ∂*T* of the target tube 20 amounts for the initial diameter of 100 mm and a δT of 100K to about δd = 0.23 mm. This results in a sufficient mounting clearance, i.e. radial distance when coaxially arranged, between the target tube 20 and the backing tube 10 of about 0.1 mm. Typically, the outer surface 12 of the middle part 110, i.e. the outer lateral area 12a, and the outer surface 12 of at least one of the two end regions 120 and 130 of the backing tube 10 as well as the inner lateral area 22 of the target tube 20 have a surface roughness which is below 0.05 mm. This allows for a frictionless or at least low friction arranging of the target tube 20 around the backing tube 10. During the subsequent thermal relaxation a shrink fit connection is formed between the backing tube 10 and the target tube 20. The thereby formed rotatable target 100 may be used in a sputtering installation 200. To avoid expansion of the backing tube 10 during assembly and/or to speed up the temperature equalization and relaxation, respectively, the backing tube 10 may be cooled.

As already mentioned above, the target tube 10 may also be shrink-fitted in sections to the target tube 20. This means that the methods 1000 of Fig. 9 and 10 may be carried out iteratively for sections of the target tube 10.

In another embodiment, the sections of the target tube 20 are arranged one after the other on the backing tube 10 with essentially the same initial temperature difference to the backing tube 10 or with different initial temperature differences which are larger than a minimum initial temperature difference to the backing tube 10. Thereafter, the sections are shrink fitted to the backing tube 10 in a common process of reducing the temperature difference and temperature differences, respectively.

Typically after a few days or a week of use, the target tube 20 of an installed rotatable target 100 is worn. A used rotatable target 100' having an almost completely worn target tube 20' has typically to be exchanged. According to an embodiment, which may be combined with other embodiments disclosed herein, the backing tube 10 of a used rotatable target 100' is reused. This is explained with reference to Fig. 11. Accordingly, the process 500 of the method 1000 includes a sub process 510 of providing a rotatable target 100' with a backing tube 10 and a worn target tube 20'. The thickness of the worn target tube 20' may be irregular and is typically less than 1 mm. In a sub process 520 the thin worn target tube 20' is cut, e.g. with a cutting tool or a milling machine, typically in a longitudinal direction of the backing tube 10. Thereafter, the worn target tube 20' is removed, e.g. pulled off, in sub process 530. This is typically followed by cleaning the backing tube 10 prior to shrink fitting a new target tube 20 to it as explained with reference to Fig. 9 and Fig. 10. In doing so, the backing tube may be reused. Reusing the backing tube typically reduces costs and is more environmentally friendly.

According to an embodiment, a reusable backing tube 10 with a notch 15 on the outer surface 12, 12a, as has been explained with reference to Fig. 6, 7A and 7B, is used in the process 500 of Figs. 9 to 11. The notch 15 facilitates the cutting process 520 as the cutting tool or the milling machine may cut the worn target 20' along the notch 15. This reduces the risk of damaging the outer surface 12, 12a of the backing tube 10. Therefore, the notch 15 typically extends in longitudinal direction along the outer lateral area 12a which is adapted to receive the target tube 20. Furthermore, the outer lateral area 12a of the backing tube 10 is, in the lateral direction, typically a bit larger than the target tube 20 to facilitate positioning and/or putting on the cutting tool or the milling head of the milling machine. Typically, the longitudinal extension of the outer lateral area 12a and the notch 15, respectively, is about 5 mm to about 10 mm larger than the longitudinal extension of the backing tube 10. Alternatively and/or in addition, at least one of the first and second end regions 120, 130 includes a position mark next to the notch 15 on the outer surface 12 for this purpose.

According to an embodiment, the backing tube is provided by cutting the target tube in a longitudinal direction and/or removing the target tube of a rotatable target having a backing tube and a target tube. Typically, the rotatable target is a worn rotatable target of a reusable backing tube and a used and/or worn target tube.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A rotatable target (100) for a sputtering installation (200), comprising:
- a backing tube (10); and
- a target tube (20) shrink-fitted to the backing tube (10).

2. The rotatable target of claim 1, wherein the backing tube (10) comprises an outer surface (12), and wherein the target tube (20) comprises an inner lateral area (22), the inner lateral area (22) of the target tube (20) and at least a part (12a) of the outer surface (12) of the backing tube (10) being pressed against each other.

3. The rotatable target (100) of claim 1 or 2, wherein the backing tube (10) has a first coefficient of expansion, and wherein the target tube (20) has a second coefficient of expansion which is equal to or smaller than the first coefficient of expansion.

4. The rotatable target (100) of any of the preceding claims, wherein the target tube (20) comprises and/or is made of a first material, and wherein the backing tube (10) comprises the first material.

5. The rotatable target (100) of claim 4, wherein the first material is selected from a group consisting of an elemental metal, a metal alloy and a semiconductor material.

6. The rotatable target (100) of any of the claims 2 to 5, wherein the backing tube (10) further comprises:
- a middle part (110) having a first outer diameter (d1) and an outer lateral area (12a) which adjoins the inner lateral area (22);
- a first end region (120) adapted to be mounted to the sputtering installation (200) and having an outer diameter which is equal to or smaller than the first outer diameter (d1); and
- a second end region (130) arranged at an end of the backing tube (10) which is opposite to the first end region (120).

7. The rotatable target (100) of claim 6, wherein the middle part (110) further comprises a notch (15) on the outer lateral area (12a), the notch (15) optionally extending in a longitudinal direction of the backing tube (10).

8. The rotatable target of claim 6 or 7, wherein the second end region (130) comprises a maximum outer diameter (d2) which is larger than the first outer diameter (d1).

9. A sputtering installation (200) comprising a rotatable target (100) of any of the preceding claims.

10. A backing tube (10) adapted to receive a target tube (20) and comprising:
- a first end region (120) adapted to be mounted to a sputtering installation (200);
- a middle part (110) comprising an outer lateral area (12a) and a notch (15) extending in a longitudinal direction on the outer lateral area (12a); and
- a second end region (130) arranged opposite to the first end region (120).

11. A method for producing a rotatable target (100), comprising:
- providing a backing tube (10) adapted to be mounted to a sputtering installation (200);
- providing a target tube (20);
- setting a temperature difference between a first temperature of the target tube (20) and a second temperature of the backing tube (10), the temperature difference being larger than zero;
- pulling the target tube (20) over the backing tube (10) while the temperature difference remains larger than zero.

12. The method of claim 11, further comprising:
- reducing the temperature difference to form a shrink fit connection between the target tube (20) and the backing tube (10).

13. The method of claims 11 or 12, wherein setting a temperature difference comprises at least one of:
- heating the target tube (20); and
- cooling the backing tube (10).

14. The method of any of the claims 11 to 13, wherein the backing tube (10) comprises a hollow cylindrical middle part (110) adapted to receive the target tube (20), and wherein the temperature difference is set such that the hollow cylindrical middle part (110) comprises an outer diameter (d1), and that the target tube (20) comprises an inner diameter (d1') which is about 0.01 mm to about 1.5 mm larger than the outer diameter (d1).

15. The method of any of the claims 11 to 14, wherein providing a backing tube (10) comprises providing a rotatable target (100') comprising a backing tube (10) and a target tube (20'), further comprising at least one of:
- cutting the target tube (20') in a longitudinal direction, typically along a notch (15) provided on the backing tube (10); and
- removing the target tube (20').

## Amended claims

### Amended claims in accordance with Rule 137(2) EPC.

**1.** A rotatable target (100) for a sputtering installation (200), comprising:
- a backing tube (10) comprising a middle part (110) comprising an outer lateral area (12a) and a notch (15) which extends in a longitudinal direction of the backing tube (10) on the outer lateral area (12a);
- a target tube (20); and
- a shrink fit connection formed between the target tube (20) and the backing tube (10).

**2.** The rotatable target of claim 1, wherein the target tube (20) comprises an inner lateral area (22), the inner lateral area (22) of the target tube (20) and the outer lateral area (12a) of the middle part (110) of the backing tube (10) being pressed against each other.

**3.** The rotatable target (100) of claim 1 or 2, wherein the backing tube (10) has a first coefficient of expansion, and wherein the target tube (20) has a second coefficient of expansion which is equal to or smaller than the first coefficient of expansion.

**4.** The rotatable target (100) of any of the preceding claims, wherein the target tube (20) comprises and/or is made of a first material, and wherein the backing tube (10) comprises the first material.

**5.** The rotatable target (100) of claim 4, wherein the first material is selected from a group consisting of an elemental metal, a metal alloy and a semiconductor material.

**6.** The rotatable target (100) of any of the claims 2 to 5, wherein the middle part (110) has a first outer diameter (d1), wherein the outer lateral area (12a) adjoins the inner lateral area (22), and wherein the backing tube (10) further comprises:
- a first end region (120) adapted to be mounted to the sputtering installation (200) and having an outer diameter which is equal to or smaller than the first outer diameter (d1); and
- a second end region (130) arranged at an end of the backing tube (10) which is opposite to the first end region (120).

**7.** The rotatable target of claim 6, wherein the second end region (130) comprises a maximum outer diameter (d2) which is larger than the first outer diameter (d1).

**8.** A sputtering installation (200) comprising a rotatable target (100) of any of the preceding claims.

**9.** A backing tube (10) adapted to receive a target tube (20) and comprising:
- a first end region (120) adapted to be mounted to a sputtering installation (200);
- a middle part (110) comprising an outer lateral area (12a) and a notch (15) extending in a longitudinal direction on the outer lateral area (12a), the notch (15) having a lateral extension of about 1 mm to about 5 mm and extending about 0.5 mm to about 2 mm from outside into a shell of the backing tube (10) without going through the shell; and
- a second end region (130) arranged opposite to the first end region (120).

**10.** A method for producing a rotatable target (100), comprising:
- providing a backing tube (10) adapted to be mounted to a sputtering installation (200), the backing tube (10) comprising a middle part (110) comprising an outer lateral area (12a) and a notch (15) which extends in a longitudinal direction of the backing tube (10) on the outer lateral area (12a);
- providing a target tube (20);
- setting a temperature difference between a first temperature of the target tube (20) and a second temperature of the backing tube (10), the temperature difference being larger than zero;
- pulling the target tube (20) over the backing tube (10) while the temperature difference remains larger than zero.

**11.** The method of claim 10, further comprising:
- reducing the temperature difference to form a shrink fit connection between the target tube (20) and the backing tube (10).

**12.** The method of claim 10 or 11, wherein setting a temperature difference comprises at least one of:
- heating the target tube (20); and
- cooling the backing tube (10).

**13.** The method of any of the claims 10 to 12, wherein the middle part (110) is formed as a hollow cylindrical middle part (110) which is adapted to receive the target tube (20), and wherein the temperature difference is set such that the hollow cylindrical middle part (110) comprises an outer diameter (d1), and that the target tube (20) comprises an inner diameter (dl') which is about 0.01 mm to about 1.5 mm larger than the outer diameter (d1).

**14.** The method of any of the claims 10 to 13, wherein providing a backing tube (10) comprises providing a rotatable target (100') comprising a backing tube (10) and a target tube (20'), further comprising:
- cutting the target tube (20') in a longitudinal direction along the notch (15) of the middle part (110).

**15.** The method of claim 14, further comprising:
- removing the target tube (20').
